(19) Europäisches Patentamt
European Patent Office
Office européen des brevets

(11) **EP 3 039 785 B1**

(12) **EUROPÄISCHE PATENTSCHRIFT**

(45) Veröffentlichungstag und Bekanntmachung des Hinweises auf die Patenterteilung:
**16.12.2020   Patentblatt 2020/51**

(21) Anmeldenummer: **14739106.4**

(22) Anmeldetag: **08.07.2014**

(51) Int Cl.:
***H03H 7/38*** *(2006.01)*

(86) Internationale Anmeldenummer:
**PCT/EP2014/064600**

(87) Internationale Veröffentlichungsnummer:
**WO 2015/028181 (05.03.2015 Gazette 2015/09)**

(54) **VERFAHREN ZUR OPTIMIERUNG DER IMPEDANZ EINES VERBINDUNGSELEMENTS**

METHOD FOR OPTIMIZING THE IMPEDANCE OF A CONNECTION ELEMENT

PROCÉDÉ D'OPTIMISATION DE L'IMPÉDANCE D'UN ÉLÉMENT DE LIAISON

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **30.08.2013   DE 102013109463**

(43) Veröffentlichungstag der Anmeldung:
**06.07.2016   Patentblatt 2016/27**

(73) Patentinhaber: **Endress+Hauser SE+Co. KG 79689 Maulburg (DE)**

(72) Erfinder: **BLÖDT, Thomas 79585 Steinen (DE)**

(74) Vertreter: **Andres, Angelika Maria Endress+Hauser Group Services (Deutschland) AG+Co. KG Colmarer Straße 6 79576 Weil am Rhein (DE)**

(56) Entgegenhaltungen:
**EP-A1- 1 168 604     WO-A1-2011/134635**

- **CUTHBERT T R: "BROADBAND IMPEDANCE MATCHING METHODS", RF DESIGN, PRIMEDIA BUSINESS MAGAZINES & MEDIA, OVERLAND PARK, KS, US, Bd. 17, Nr. 8, 1. August 1994 (1994-08-01) , Seiten 64,66-71, XP000460206, ISSN: 0163-321X**
- **RAHOLA J: "Power Waves and Conjugate Matching", IEEE TRANSACTIONS ON CIRCUITS AND SYSTEMS II: EXPRESS BRIEFS, IEEE, US, Bd. 55, Nr. 1, 1. Januar 2008 (2008-01-01) , Seiten 92-96, XP011333816, ISSN: 1549-7747, DOI: 10.1109/TCSII.2007.905420**

**Beschreibung**

Die Erfindung bezieht sich auf ein Verfahren zur Optimierung der Impedanz eines Verbindungselements zwischen zwei Baugruppen einer Hochfrequenz-Vorrichtung bzw. eines Feldgeräts.

In der Automatisierungstechnik, insbesondere in der Prozessautomatisierungstechnik werden vielfach Feldgeräte eingesetzt, die zur Erfassung und/oder Beeinflussung von Prozessvariablen dienen. Ein Feldgerät ist dabei insbesondere ausgewählt aus einer Gruppe bestehend aus Durchflussmessgeräten, Füllstandsmessgeräte, Druckmessgeräte, Temperaturmessgerät, Grenzstandsmessgeräte und/oder Analysemessgeräte.

Durchflussmessgeräte sind insbesondere Coriolis-, Ultraschall-, Vortex-, thermischen und/oder magnetisch induktiven Durchflussmessgeräte. Füllstandsmessgeräte sind insbesondere Mikrowellen-Füllstandsmessgeräte, Ultraschall-Füllstandsmessgeräte, zeitbereichsreflektometrische Füllstandsmessgeräte (TDR), radiometrische Füllstandsmessgeräte, kapazitive Füllstandsmessgeräte, induktive Füllstandsmessgeräte und/oder temperatursensitive Füllstandsmessgeräte. Druckmessgeräte sind insbesondere Absolut-, Relativ- oder Differenzdruckgeräte. Temperaturmessgeräte sind insbesondere Messgeräte mit Thermoelementen und temperaturabhängigen Widerständen. Grenzstandsmessgeräte sind insbesondere vibronische Ultraschall-Grenzstandsmessgeräte und/oder kapazitive Grenzstandsmessgeräte.
Analysemessgeräte sind insbesondere pH-Sensoren, Leitfähigkeitssensoren, Sauerstoff- und Aktivsauerstoffsensoren, (spektro)-photometrische Sensoren, und/oder ionenselektive Elektroden.
Eine Vielzahl solcher Feldgeräte wird von der Firma Endress + Hauser hergestellt und vertrieben.

Hochfrequenz-Vorrichtungen, wie zum Beispiel Feldgeräte, bestehen aus mehreren Baugruppen, die mit einer Betriebsfrequenz oder mit Teilern der Betriebsfrequenz arbeiten. Beispielsweise arbeitet das auf Radarmessungen basierende Füllstandsmessgerät Micropilot ES FMR50 der Anmelderin Endress + Hauser mit einer Betriebsfrequenz von 25.5 GHz. Die Arbeitsfrequenzen der einzelnen Baugruppen dieses Füllstandsmessgeräts betragen 25.5 GHz, 12.75 GHz, 750 MHz oder 1.5 GHz, 300 MHz und 140 kHz.

Insbesondere mit steigenden Frequenzen kommt es vermehrt zu Reflexionen in der Verbindungsleitung zwischen den einzelnen Baugruppen. Abhängig vom verwendeten Radarmessprinzip (Pulsradar, moduliertes Dauerstrichradar (sog. FMCW), Doppler-Radar etc.) können die Reflexionen Auswirkungen auf die Messgenauigkeit, die Messlinearität, die Auflösung und die maximale Messdistanz aufweisen. Darüber hinaus werden bei gepulsten Signalen die Pulsformen durch Reflexionen beeinflusst. Hieraus ergibt sich bei einer definierten Pulsbreite der ausgesendeten Signalpulse eine größere Pulsbreite, die mit dem benachbarten Signalpuls interferieren kann. Das Interferieren eines Signalpulses mit dem benachbarten Signalpuls hat Auswirkungen auf die Messungenauigkeit, die sich mit größer werdender Distanz zwischen Sender und Empfänger des Signalpulses stärker bemerkbar macht.

Es gibt Verfahren zur Verminderung von Reflexionen in Verbindungsleitungen zwischen zwei Baugruppen einer Hochfrequenzvorrichtung. In Radarsystemen zur Füllstandsmessung wird üblicherweise die Leitungsimpedanz zweier verbundener Baugruppen jeweils auf 50 Ohm festgelegt. Hierbei werden lediglich die ohmschen Widerstände und nicht die Blindwiderstände der Baugruppen betrachtet.

Werden zwei Baugruppen mittels einer entsprechenden Verbindungsleitung miteinander verbunden, tritt aufgrund gleicher ohmscher Widerstände der beiden Baugruppen rein theoretisch keine Reflexion auf. In der Realität weisen Baugruppen jedoch immer einen Blindwiderstand auf, der bei der Vermeidung von Reflexionen in der Verbindungsleitung berücksichtigt werden muss.

Diese Berücksichtigung findet in dem Verfahren der Impedanzanpassung statt. Hierbei wird die Impedanz der ersten Baugruppe mit der komplex konjugierten Impedanz der zweiten Baugruppe gleich gesetzt. Die Impedanzen sind komplexwertig und bestehen aus einem Real- und einem Imaginärteil, die beide frequenzabhängig sind. Der Imaginärteil repräsentiert hierbei die Laufzeit einer Reflexion bei der jeweils betrachteten Frequenz. Durch die Impedanzanpassung werden Reflexionen zwischen zwei Baugruppen optimal unterdrückt. Problematisch sind hier beispielsweise Toleranzen der Baugruppen und die Bestückungsungenauigkeit in der Serienfertigung.

Das Verfahren der Impedanzanpassung ist nicht nur für die vorgesehenen Betriebs- bzw. Arbeitsfrequenzen, sondern auch für benachbarte Frequenzen geeignet. Auf diese Weise ergibt sich ein Frequenzband, für das die Impedanzanpassung annähernd gilt. Insbesondere Radargeräte nach dem Prinzip des modulierten Dauerstrichs (FMCW) weisen ein Frequenzband auf. Pulsradargeräte weisen ein Frequenzband mit einer Mittenfrequenz auf, wobei die höchste Leistungsdichte bei der Mittenfrequenz vorliegt. Frequenzen um die Mittenfrequenz müssen daher besonders berücksichtigt werden, um Impedanzanpassung für das gesamte Frequenzband zu erreichen.

Die Impedanzanpassung lässt sich mittels Anpassstrukturen der Verbindungsleitung realisieren. Gilt eine Impedanzanpassung näherungsweise für ein ganzes Frequenzband, führt dies zu Anpassstrukturen der Verbindungsleitung, die im gesamten Frequenzband die Signalpulse mit gleichbleibender Gruppenlaufzeit übertragen. Auf diese Weise werden Dispersionseffekte in den Signalpulsen vermieden. Bei der Verwendung eines Dauerstrichsignals (FMCW) spielt dies nur eine untergeordnete Rolle.

Aus dem Stand der Technik ist ein Verfahren zur Verringerung von Reflexionen bekannt, bei dem eine absorbierende Dämpfungsmatte auf eine leiterkartenintegrierte Hochfrequenz-Verbindungsleitung geklebt wird. Derartige Dämpfungsmatten werden unter der Handelsbezeichnung "Eccosorb" angeboten. Seit neuestem sind Materialien mit ähnlichen Eigenschaften auch als Paste verfügbar. Der Nachteil einer Dämpfungsmatte ist ein unerwünschter Signalverlust, der insbesondere bei 4-20 mA Geräten nachteilig ist. Ferner ergibt sich bei Pulsradarsystemen eine Obergrenze für die Dämpfung nach dem Korrelationsprinzip (sog. Dynamik), die sich am Korrelator als Rauschniveau und verringerte Amplitude des Nutzechos bemerkbar macht. Ferner weisen die meisten Baugruppen mehrere Pegelzustände auf, die sich jeweils durch unterschiedliche Impedanzen unterscheiden.

Die EP 1 168 604 A1 offenbart eine Anpassungsschaltung, bestehend aus einer einstufigen Anpassungseinheit als Hochpassfilter und einer einstufigen Anpassungseinheit als Tiefpassfilter, die in Reihe miteinander verbunden sind. Dadurch können eine Ausgangslastimpedanz eines vorderstufigen Verstärkungselements und eine Eingangsquellenimpedanz eines hinterstufigen Verstärkungselements gleichzeitig mit jeweils optimalen Impedanzen angepasst werden.

Die WO 2011/134635 A1 offenbart eine elektronische Schaltung mit mehreren Quellenelementen und Anpassnetzwerken, welche basierend auf Poincare - Kreisen von Reflexionsfaktoren ausgelegt sind, um die elektronische Schaltung optimal auszulegen.

Der Erfindung liegt die Aufgabe zugrunde, Reflexionen in einer Verbindungsleitung für möglichst viele Pegelzustände der Baugruppen und für ein möglichst breitbandiges Frequenzband ohne nennenswerten Leistungsverlust zu vermeiden.

Die Aufgabe wird erfindungsgemäß durch den Gegenstand des Anspruchs 1 gelöst. Der Gegenstand des Anspruchs 1 beinhaltet ein Verfahren zur Optimierung der Impedanz eines Verbindungselements zwischen einer ersten Baugruppe und einer zweiten Baugruppe einer Hochfrequenz-Vorrichtung, insbesondere eines Feldgeräts, wobei die erste Baugruppe und die zweite Baugruppe jeweils mindestens zwei Pegelzustände aufweisen, wobei das Verbindungselement eine Eingangsimpedanz und eine Ausgangsimpedanz aufweist, wobei die erste Baugruppe in jedem ihrer mindestens zwei Pegelzustände jeweils eine Impedanz aufweist, wobei die zweite Baugruppe in jedem ihrer mindestens zwei Pegelzustände jeweils eine Impedanz aufweist, umfassend die Schritte, Bestimmen von jeweils einem Betrag einer Differenz für die erste Baugruppe zwischen der komplex konjugierten Eingangsimpedanz und der jeweils einen Impedanz der ersten Baugruppe in jedem ihrer mindestens zwei Pegelzustände, Bestimmen von jeweils einem Betrag einer Differenz für die zweite Baugruppe zwischen der komplex konjugierten Ausgangsimpedanz und der jeweils einen Impedanz der zweiten Baugruppe in jedem ihrer Pegelzustände, Minimieren einer Summe der jeweiligen Beträge der Differenzen der ersten Baugruppe und der zweiten Baugruppe bezüglich der Ein- und Ausgangsimpedanz des Verbindungselements.

Erfindungsgemäß wird die Aufgabe dadurch gelöst, dass die Eingangs- und Ausgangsimpedanz des Verbindungselements gleichzeitig an die Impedanzen der ersten und der zweiten Baugruppe für alle Pegelzustände optimiert werden, anstatt nur an die Impedanzen der ersten und der zweiten Baugruppe in einem Pegelzustand angepasst zu werden.

Gemäß einer vorteilhaften Weiterbildung werden die jeweiligen Beträge vor dem Minimieren der Summe gewichtet. Durch das Gewichten tragen die Pegelzustände, die am häufigsten vorkommen oder am meisten Energie verbrauchen oder ein breitbandiges Frequenzband aufweisen stärker zur Bestimmung der Impedanz des Verbindungselements bei.

Gemäß einer vorteilhaften Variante wird mindestens eine der jeweiligen Beträge der Differenzen, die keinen Einfluss auf die Optimierung der Eingangs- und Ausgangsimpedanz des Verbindungselements ausübt, mit Null gewichtet. Auf diese Weise werden die Pegelzustände, die keine Rolle bei der Berechnung der Impedanz des Verbindungselements spielen, nicht zur Bestimmung der Impedanz des Verbindungselements herangezogen.

Gemäß einer vorteilhaften Ausführung wird die Gewichtung der mindestens einen der jeweiligen Beträge der Differenzen aufgrund der Gewichtung der Eingangsleistung und/oder der Eingangsspannung und/oder des Eingangsstroms der ersten oder zweiten Baugruppe bestimmt. Eingangsleistung und/oder Eingangsspannung und/oder Eingangsstroms jeder Baugruppe werden zur Bestimmung der Impedanz der jeweiligen Baugruppe herangezogen. Falls eine Gewichtung dieser Größen empirisch oder durch Simulation ermittelt werden kann, lassen sich diese Gewichtungen auf die Gewichtung der Impedanz des Verbindungselements übertragen.

Die Aufgabe der Erfindung wird ebenfalls durch ein Verbindungselement zur Optimierung der Impedanz zwischen einer ersten Baugruppe (E1) und einer zweiten Baugruppe einer Hochfrequenz-Vorrichtung, insbesondere eines Feldgeräts, wobei die erste Baugruppe und die zweite Baugruppe jeweils mindestens zwei Pegelzustände aufweisen, wobei das Verbindungselement eine Eingangsimpedanz und eine Ausgangsimpedanz aufweist, wobei die erste Baugruppe in jedem ihrer mindestens zwei Pegelzustände jeweils eine Impedanz aufweist, wobei die zweite Baugruppe in jedem ihrer mindestens zwei Pegelzustände jeweils eine Impedanz aufweist, wobei eine Summe aus einem Betrag einer Differenz für die erste Baugruppe zwischen einer komplex konjugierten Eingangsimpedanz und der jeweils einen Impedanz der ersten Baugruppe und aus einem Betrag einer Differenz für die zweite Baugruppe zwischen einer komplex konjugierten Ausgangsimpedanz und der jeweils einen Impedanz der zweiten Baugruppe minimiert ist, gelöst.

Ein Verbindungselement, das mittels des erfindungsgemäßen Verfahrens hergestellt wurde, kann ebenfalls zur Vermeidung von Reflexionen zwischen zwei Baugruppen verwendet werden.

Gemäß einer vorteilhaften Weiterbildung weist das Verbindungselement eine Anpassstruktur auf, die eine Eingangs- und Ausgangsimpedanz aufweist, dessen Beträge der ersten Baugruppe und dessen Beträge der zweiten Baugruppe bezüglich der Eingangs- und Ausgangsimpedanz optimiert sind. Auf diese Weise ist es nicht notwendig das Verbindungselement komplett auszutauschen. Die Anpassstruktur wird einfach an das Verbindungselement angeschlossen.

Gemäß einer vorteilhaften Ausgestaltung ist das Verbindungselement als eine elektrische Verbindungsleitung ausgestaltet.

Gemäß einer vorteilhaften Weiterbildung umfasst das Verbindungselement mindestens einen Widerstand und/oder mindestens einen Kondensator und/oder mindestens eine Spule umfasst.

Die Erfindung wird anhand der nachfolgenden Zeichnungen näher erläutert. Es zeigt:

Fig. 1a - d: vier verschiedene Signalpulse im Spannung-Zeit-Diagramm nach dem Stand der Technik, die innerhalb eines Feldgeräts zwischen verschiedenen Baugruppen ausgetauscht werden,

Fig. 2: einen schematischen Schaltplan eines Feldgeräts nach dem Stand der Technik mit zwölf Baugruppen D1 - D12,

Fig. 3: zwei Baugruppen nach dem Stand der Technik, die mittels einer Verbindungsleitung miteinander verbunden sind, wobei die Verbindungsleitung eine Dämpfungsmatte aufweist,

Fig. 4: zwei beliebige Baugruppen nach dem Stand der Technik, die mittels einer Verbindungsleitung miteinander verbunden sind mit einem Punkt F von dem aus die Impedanzen der Baugruppen betrachtet werden.

Fig. 5: zwei beliebige Baugruppen, die mittels einer Verbindungsleitung miteinander verbunden sind, wobei die Verbindungsleitung eine Anpassstruktur aufweist,

Fig. 6: ein erstes Diagramm, das die Eingangs- und Ausgangsleistung für die verschiedenen Pegelzustände des Verstärkers zeigt,

Fig. 7: ein zweites Diagramm, das die Eingangs- und Ausgangsleistung für die verschiedenen Pegelzustände des Verstärkers zeigt, wobei die Pegelzustände mittels einer ersten Gewichtung gewichtet sind, und

Fig. 8: ein drittes Diagramm, das die Eingangs- und Ausgangsleistung für die verschiedenen Pegelzustände des Verstärkers zeigt, wobei die Pegelzustände mittels einer zweiten Gewichtung gewichtet sind, und

Fig. 9: eine Schaltung einer Baugruppe, die als Verstärker ausgestaltet ist.

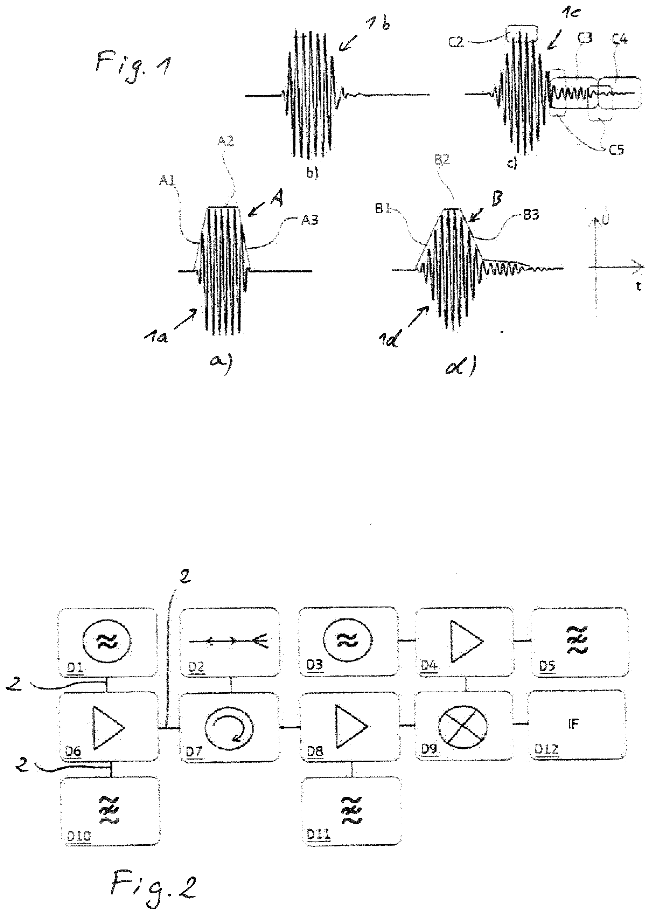

Fig. 1 a - d zeigen jeweils einen Signalpuls nach dem Stand der Technik, der innerhalb eines Feldgeräts zwischen den verschiedenen Baugruppen ausgetauscht werden. Ist ein Signal gepulst, besteht der Signalpuls aus einer Überlagerung mehrerer Schwingungen. Der einzelne Signalpuls kann durch eine Kurve eingehüllt werden, die idealerweise die Form einer Gauß-Kurve aufweist.

Fig. 1a zeigt einen erzeugten ersten Signalpuls 1a, dessen erste Hüllkurve A eine erste ansteigende Flanke A1, einen ersten Bereich mit einem waagerechten Verlauf A2 und eine erste abfallende Flanke A3 aufweist.

Fig. 1b zeigt einen zweiten Signalpuls 1b, der mindestens eine Baugruppe durchlaufen hat und eine geringe Abweichung gegenüber dem erzeugten Signalpuls 1a in Fig. 1a aufweist.

Fig. 1c zeigt einen dritten Signalpuls 1c, der mehrere Baugruppen durchlaufen hat und deutliche Unterschiede zum erzeugten Signalpuls 1a in Fig. 1a aufweist. Der dritte Signalpuls 1c weist eine verkürzte Amplitude C2, Reflexionen C3, Mehrfach-Reflexionen C4 und Schwebungen C5 auf.

Fig. 1d zeigt einen vierten Signalpuls 1d entsprechend dem Signalpuls 1c in Fig. 1c mit einer zweiten Hüllkurve B, die den Signalpuls 1d einhüllt. Die Hüllkurve B weist eine zweite ansteigende Flanke B1, einen zweiten Bereich mit waagrechtem Verlauf B2 und eine zweite abfallende Flanke B3 auf. Die zweite ansteigende und abfallende Flanke B1, B3 sind flacher ausgebildet als die erste ansteigende und abfallende Flanke A1, A3 bei dem Signalpuls 1a in Fig. 1a. Dementsprechend ist der zweite Bereich mit waagrechtem Verlauf B2 kürzer ausgestaltet als der erste Bereich mit waagrechtem Verlauf A2 des Signalpulses 1a in Fig. 1a. Diese Veränderungen, die ein Signalpuls nach dem Durchlaufen der Baugruppen erleidet, sind weitestgehend auf Reflexionen zurückzuführen, die sich in einer Verbindungsleitung ereignen.

Fig. 2 zeigt einen schematischen Schaltplan eines Feldgeräts nach dem Stand der Technik mit zwölf Baugruppen D1 - D12 und ihre Verbindungsleitungen 2. Die elektronischen Baugruppen D1 - D12 sind in der Geräteserie Micropilot ES FMR 5x des Unternehmens Endress + Hauser realisiert. Die elektronischen Hochfrequenz-Baugruppen D1 - D12 sind entweder als aktive oder passive Baugruppen ausgestaltet. Die passiven Baugruppen sind beispielsweise die Filter D5, D10, D11, die Antenne D2 und Unterbaugruppen als Bias (Spannungs- oder Stromversorgung) innerhalb der Oszillatoren D1, D3 oder die Verstärker D4, D6, D8. Aktive Baugruppen sind beispielsweise die Oszillatoren D1, D3 und die Verstärker D4, D6, D8 sowie der Mischer D9.

Reflexionen können besonders zwischen Oszillatoren D1 und D3, zwischen jeweils zwei der Verstärker D4, D6 und D8 und zwischen dem Mischer D9 und der Zwischenfrequenzstufe D12 auftreten. Die Rückwirkung der Zwischenfrequenzstufe D12 auf den Mischer D9 ist aufgrund des großen Frequenz- und Impedanz-Unterschieds sehr gering, wurde jedoch schon messtechnisch nachgewiesen und sollte daher beachtet werden. Ferner können Reflexionen zwischen jeweils zwei der Baugruppen, wie zum Beispiel die Sende-Empfangsweichen D7, der Mischer D9, die Antennen D2, sowie die Ansteuerungen und deren Bias D5, D10, D11 auftreten.

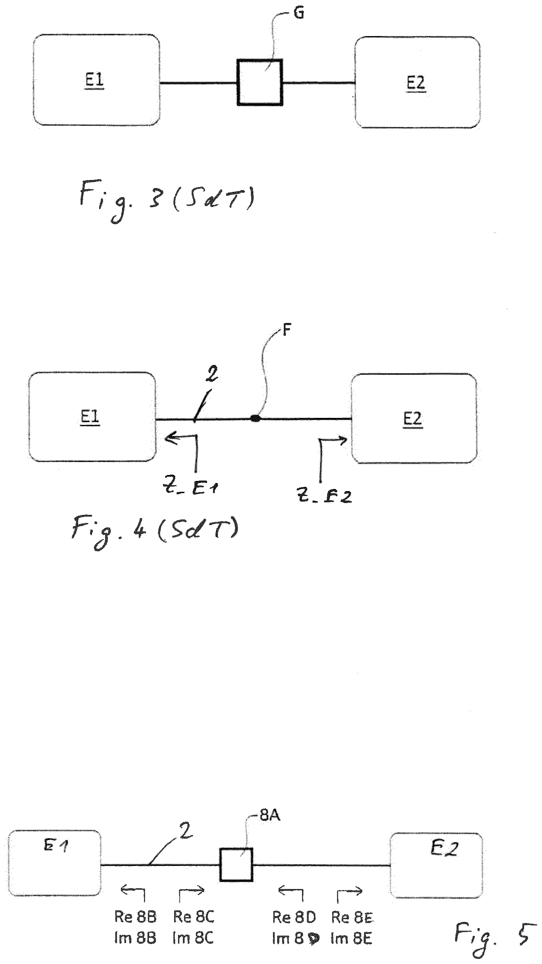

Fig. 3 zeigt schematisch eine Dämpfungsmatte G nach dem Stand der Technik zwischen zwei beliebigen Baugruppen E1 und E2 nach dem Stand der Technik. Die Dämpfungsmatte G verringert die Reflexionen in leiterkartenintegrierten Hochfrequenz-Verbindungsleitungen. Hierzu wird die Dämpfungsmatte G auf die Verbindungsleitung 2 geklebt oder in Form einer Paste auf die Verbindungsleitung 2 geschmiert. Nachteilig an solchen Dämpfungsmatten G ist der hohe Signalverlust. Der Grad der Dämpfung entspricht in der Wirkung etwa der Dämpfung des transmittierten Signalpulses.

Fig. 4 zeigt zwei beliebige Baugruppen E1, E2 des Feldgeräts, die mittels einer Verbindungsleitung 2 elektrisch verbunden sind. Es werden von einem beliebigen Punkt F der Verbindungsleitung 2 eine erste Impedanz $Z\_E1$ und eine zweite Impedanz $Z\_E2$ der ersten und der zweiten Baugruppen E1, E2 betrachtet. Die Impedanzanpassung im Punkt F ergibt sich aus

$$Z\_E1 = Z\_E2^* \qquad\qquad\qquad G1$$

Wobei $Z\_E2^*$ die komplex konjugierte Impedanz von $Z\_E2$ ist. Aus der Formel G1 ergibt sich

$$Re\ Z\_E1 = Re\ Z\_E2 \quad \text{und} \quad Im\ Z\_E1 = -\ Im\ Z\_E2 \qquad\qquad G2$$

Da die Gleichungen G1 bzw. G2 lediglich für eine einzige Frequenz lösbar sind und nicht für ein Frequenzband, müssen die Gleichungen näherungsweise betrachtet werden. Die Näherungsgleichungen ergeben sich dann zu

$$Re\ Z\_E1 \approx Re\ Z\_E2 \quad \text{und} \quad Im\ Z\_E1 \approx -\ Im\ Z\_E2 \qquad\qquad G3$$

Fig. 5 zeigt die erste und zweite Baugruppe E1, E2 mit einer Verbindungsleitung 2, die eine Anpassstruktur 8A aufweist. Die Anpassstruktur 8A weist eine Eingangs- und eine Ausgangsimpedanz 8C und 8D auf. Die erste Baugruppe E1 weist eine erste Impedanz 8B und die zweite Baugruppe E2 weist eine zweite Impedanz 8E auf. Weisen die erste und zweite Baugruppe E1, E2 mehrere Pegelzustände Z1, Z2, ... auf, ergeben sich für die erste und zweite Baugruppe E1, E2 für jeden Pegelzustand Z1, Z2, ... jeweils eine Impedanz 8B_1, 8B_2, ... der ersten Baugruppe E1 und eine Impedanz 8E_1, 8E_2, ... der zweiten Baugruppe E2, wobei die jeweiligen Impedanzen 8B_1, 8B_2, ... bzw. 8E_1, 8E_2, ... der ersten und zweiten Baugruppe E1, E2 bekannt sind. Für eine Impedanzanpassung der Anpassstruktur 8A an die erste und zweite Impedanz 8B, 8E müssen die Eingangs- und Ausgangsimpedanz 8C und 8D der Anpassstruktur 8A jeweils an die erste und zweite Impedanz 8B und 8E der ersten und zweiten Baugruppe E1, E2 angepasst werden. Hierzu werden sämtliche Impedanzen 8B, 8C, 8D und 8E in der Gaußebene betrachtet, da sie komplexwertig sind. In der Gaußebene bezeichnen die Impedanzen 8B, 8C, 8D und 8E jeweils einen Punkt, der durch den Real- und Imaginärteil der Impedanzen festgelegt ist. Beispielsweise gilt für 8B:

$$8B = Re\ 8B + j * Im\ 8B \qquad\qquad\qquad G4$$

Ist Anpassstruktur 8A dermaßen mit der ersten und zweiten Baugruppen E1, E2 angeschlossen, dass die Eingangsimpedanz 8C der Anpassstruktur 8A an die erste Baugruppe E1 und die Ausgangsimpedanz 8D der Anpassstruktur 8A an die zweite Baugruppe E2 angeschlossen ist, ergibt sich entsprechend der Impedanzanpassung G1, dass

$$8B = 8C^* \quad \text{und} \quad 8D^* = 8E \qquad \text{G5}$$

gleichzeitig erfüllt sein muss, wobei 8C* die komplex konjugierte Eingangsimpedanz 8C der Anpassstruktur 8A und 8D* die komplex konjugierte Ausgangsimpedanz 8D der Anpassstruktur 8A ist. Dies bedeutet, dass der Abstand TA1 der beiden Punkte 8B und 8C* und der Abstand TA2 der beiden Punkte 8 D* und 8E in der Gaußebene gleichzeitig Null sein müssen.

Die Differenz $\Delta TA1$ zwischen der Impedanz 8B der ersten Baugruppe E1 und der komplex konjugierten Eingangsimpedanz 8C* der Anpassstruktur 8A beträgt:

$$\Delta TA1 = (Re\,8B - Re\,8C) + j * (Im\,8B + Im\,8C) \qquad \text{G6}$$

Der Betrag TA1 der Differenz $\Delta TA1$ beträgt

$$TA1 = \sqrt{[Re\,8B - Re\,8C]^2 + [Im\,8B + Im\,8C]^2} \qquad \text{G7}$$

Der Betrag TA1 ist genau der Abstand der beiden Punkte 8B und 8C* in der Gaußebene. Analog beträgt der Abstand TA2 zwischen den beiden Punkten 8D und 8E* in der Gaußebene:

$$TA2 = \sqrt{[Re\,8D - Re\,8E]^2 + [Im\,8D + Im\,8E]^2} \qquad \text{G8}$$

Es wird die Summe TA der beiden Beträge TA1 und TA2 minimiert

$$TA = TA1 + TA2 =$$
$$\sqrt{[Re\,8B - Re\,8C]^2 + [Im\,8B + Im\,8C]^2} \qquad \text{G9}$$
$$+\sqrt{[Re\,8D - Re\,8E]^2 + [Im\,8D + Im\,8E]^2}$$

Weisen die erste und zweite Baugruppe E1, E2 beispielsweise vier Pegelzustände Z1 - Z4 auf, müssen die Eingangs- und Ausgangsimpedanz 8C und 8D der Anpassstruktur 8A für alle Pegelzustände Z1 - Z4 an die erste und zweite Impedanz 8B und 8E der ersten bzw. zweiten Baugruppe E1, E2 angepasst werden. Somit ergibt sich für die Beträge TA1 und TA2: TA1_1, TA1_2, ... bzw. TA2_1, TA2_1, ... für alle Pegelzustände Z1 - Z4. Für den Gesamtbetrag aller Beträge TA1_1, TA1_2, ... bzw. TA2_1, TA2_1, ... für alle Pegelzustände Z1 - Z4 ergibt sich:

$$GB = \sqrt{[Re\,8B\_9 - Re\,8C]^2 + [Im\,8B\_9 + Im\,8C]^2}$$
$$+ \sqrt{[Re\,8D - Re\,8E\_9]^2 + [Im\,8D + Im\,8E\_9]^2}$$
$$+ \sqrt{[Re\,8B\_10 - Re\,8C]^2 + [Im\,8B\_10 + Im\,8C]^2}$$
$$+ \sqrt{[Re\,8D - Re\,8E\_10]^2 + [Im\,8D + Im\,8E\_10]^2}$$
$$+ \sqrt{[Re\,8B\_11 - Re\,8C]^2 + [Im\,8B\_11 + Im\,8C]^2} \qquad \text{G10}$$
$$+ \sqrt{[Re\,8D - Re\,8E\_11]^2 + [Im\,8D + Im\,8E\_11]^2}$$
$$+ \sqrt{[Re\,8B\_12 - Re\,8C]^2 + [Im\,8B\_12 + Im\,8C]^2}$$
$$+ \sqrt{[Re\,8D - Re\,8E\_12]^2 + [Im\,8D + Im\,8E\_12]^2}$$

Der Gesamtbetrag GB ist bezüglich der Variablen 8C und 8D zu minimieren. Die Beträge TA1 und TA2 können jeweils nur positiv oder 0 sein, d.h. eine Optimierung eines einzelnen Betrags TA1, TA2, ... im Extremen auf Kosten eines anderen Betrags ist nicht möglich. Die Ein- und Ausgangsimpedanzen 8C und 8D der Anpassstruktur 8A bei dem der Gesamtbetrag GB minimal ist, sind die optimalen Werte, um eine Anpassung der Anpassstruktur 8A an sämtliche Pegelzustände der ersten und zweiten Baugruppe E1, E2 zu erhalten.

Einige Pegelzustände sind den anderen Pegelzuständen zu bevorzugen oder zu benachteiligen. Dies resultiert aus der Tatsache, dass einige Pegelzustände häufiger vorkommen oder weniger häufig vorkommen als andere Pegelzustände oder, dass einige Pegelzustände mehr Leistung oder weniger Leistung benötigen als andere Pegelzustände. Aus diesen Gründen ist es sinnvoll die Beträge der Differenzen der jeweiligen Pegelzustände zu gewichten.

Zur Veranschaulichung des Verfahrens zur Gewichtung werden die Pegelzustände Z1 - Z4 der Baugruppe D9 (Mischer) betrachtet. Zur Vereinfachung werden lediglich 4 Pegelzustände Z1 - Z4 betrachtet. In jedem Pegelzustand Z1 - Z4 weist die Baugruppe D9 (Mischer) eine erste Eingangsleistung P_in (D8) und eine zweite Eingangsleistung P_in (D4) auf, wobei die erste Eingangsleistung P_in (D8) von der Baugruppe D8 kommt und die zweite Eingangsleistung P_in (D4) von der Baugruppe D4 kommt. Erfahrungsgemäß ergibt sich für jeden Pegelzustand Z1 - Z4 entsprechend der ersten und zweiten Eingangsleistung P_in (D8) und P_in (D4) eine bestimmte Gewichtung. Die Pegelzustände Z1 - Z4, die erste und zweite Eingangsleistung P_in (D8) und P_in (D4) und die jeweiligen Gewichtungen sind für die Baugruppe D9 in der Tabelle T1 dargestellt.

| Pegelzust. | P_in (D4) | P_in (D8) | Gew. | Beschreibung |
|---|---|---|---|---|
| Z1 | 0 W | 0 W | 0 | Baugruppen offline |
| Z2 | High | 0 W | 1 / 3 | Mischer-Treiber ohne Signal |
| Z3 | 0 W | High | 1 / 3 | Signal ohne Mischer-Treiber |
| Z4 | High | High | 1 / 3 | Signal und Mischer-Treiber |

Tabelle T1: Tabelle der Pegelzustände der Baugruppe D9 (Mischer)

Die Baugruppe D4, die als Verstärker ausgestaltet ist, befindet sich benachbart zu der Baugruppe D9. Entsprechend der Tabelle T4 der Baugruppe D9 lässt sich eine Tabelle T2 für die Baugruppe D4 herleiten. Zur Vereinfachung werden drei Pegelzustände Z5 - Z7 für den Bauteil D4 betrachtet.

Tabelle T2: vereinfachte Pegelzustände der Baugruppe D4

| Pegelzust. | P_out (D9) | I_out (D5) | Gew. | Beschreibung |
|---|---|---|---|---|
| Z5 | 0 W | 0 A | 0 | kein Signal -> keine Reflexion |
| Z6 | 0 W | High | 1 / 2 | Verstärker ohne Eingangsleistung |
| Z7 | High | High | 1 / 2 | Verstärker mit Ausgangsleistung |

Dabei sind P_out (D9) eine Ausgangsleistung der Baugruppe D4, der an den Bauteil D9 geht und I_out (D5) der Ausgangsstrom der Baugruppe D4, der an den Bauteil D5 geht.

Im Folgenden werden die Tabellen T1 und T2 miteinander verknüpft. Die Verknüpfung erfolgt folgendermaßen: Die Spalte der ersten Eingangsleistung P_in (D8) der Tabelle T1 und die Spalte des Ausgangsstroms I_out (D5) der Tabelle T2 haben keinen Einfluss auf die Verbindungsleitung 2 zwischen den Baugruppen D4 und D9 und werden daher nicht für die Verknüpfung berücksichtigt. Es werden lediglich die Spalte mit der zweiten Eingangsleistung P_in (D4) der Tabelle T1 und die Spalte Ausgangsleistung P_out (D9) der Tabelle T2 zur Verknüpfung der Tabellen T1 und T2 herangezogen.

Um die Gewichtungen der Tabellen T1 und T2 zu verknüpfen werden sämtliche Kombinationen {P_in (D4), P_out (D9)} aus der ersten Eingangsleistung P_in (D4) und der Ausgangsleistung P_out (D9) betrachtet. Es ergeben sich vier Kombinationen: {0, 0}; {0, high}; {high, 0}; {high, high}. Die Kombination {0, high} beispielsweise bedeutet, dass die erste Eingangsleistung P_in (D4) = 0 und die Ausgangsleistung P_out (D9) = high ist. Maßgebend für die Verknüpfung der Tabellen T1 und T2 ist, wie oft der Zustand zweite Eingangsleistung P_in (D4) = 0 vorkommt, nämlich genau zwei Mal (Pegelzustände Z1 und Z3) und jeweils mit einer Gewichtung von 1 / 3. Also lautet der erste Faktor für erste Eingangsleistung P_in (D4) für die Kombination (0, high): 1 / 3 + 1 / 3 = 2 / 3. Für den zweiten Faktor ist es ausschlaggebend, wie oft der Zustand P_out (D9) = high vorkommt, nämlich ebenfalls zwei Mal (Pegelzustände Z6 und Z7). Einmal mit einer Gewichtung von 0 und einmal mit einer Gewichtung von 1 / 2. Also lautet der zweite Faktor für Ausgangsleistung P_out (D9) für den Zustand (0, high): 0 + 1 /2 = 1 / 2. Anschließend wird der erste Faktor für Eingangsleistung P_in (D4) und der zweite Faktor für die Ausgangsleistung P_out (D9) zu einem Gesamtfaktor multipliziert: 2/3 * 1 / 2 = 2 / 6. Die Gewichtung für die Kombination (0, high) lautet also 2 / 6. Dieses Verfahren wird für jede der Kombinationen {P_in (D4), P_out (D9)} = {0, 0}; {0, high}; {high, 0}; {high, high} durchgeführt, so dass sich folgende Tabelle T3 mit den entsprechenden Gewichtungen ergibt.

Tabelle T3: Verknüpfung der Tabellen T1 und T2

| Pegelzust. | P_in (D4) | P_out (D9) | Gew. |
|---|---|---|---|
| Z9 | high | 0 W | 2/6 |
| Z10 | 0 W | 0 W | 1 /6 |
| Z11 | High | High | 2/6 |
| Z12 | 0 W | High | 0 |

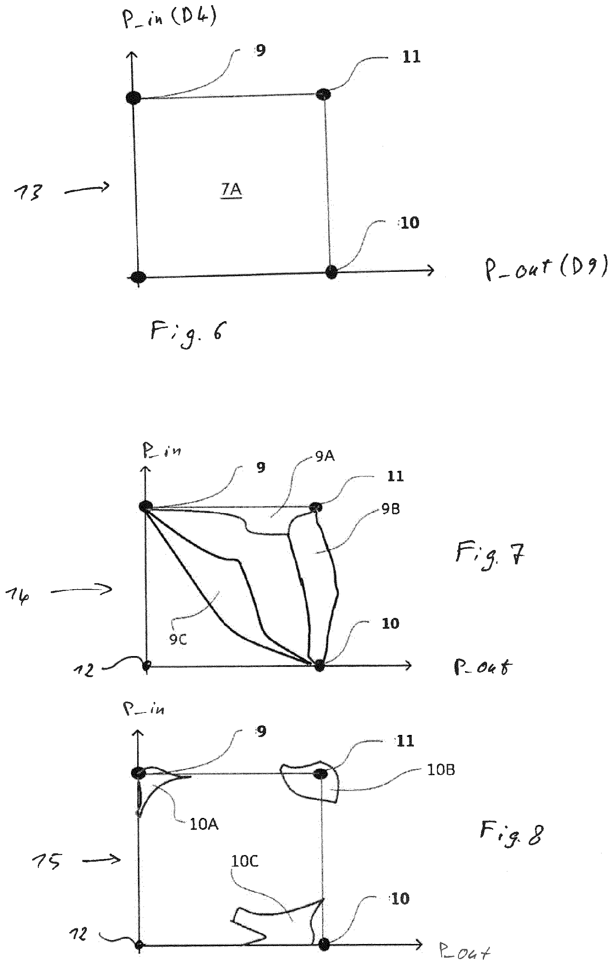

Fig. 6 zeigt ein erstes Diagramm 13 mit der ersten Eingangsleistung P_in (D4) als y-Achse und die Ausgangsleistung P_out (D9) als x-Achse. In diesem ersten Diagramm 13 sind die Pegelzustände Z9 - Z12 der Tabelle T3 eingetragen. Die Pegelzustände Z9 - Z12 begrenzen einen Bereich 7A. Innerhalb des Bereichs 7A kommen sämtliche zwischen den Pegelzuständen Z9 - Z12 liegenden Pegelzustände vor. Werden die Gewichtungen auf eins normiert, ergibt sich die nachfolgende Tabelle T4.

Tabelle T4: Auf eins normierte Gewichtungen der Tabelle T3

| Pegelzust. | Lo-In | P-Out | Gew. | Beschreibung |
|---|---|---|---|---|
| Z9 | high | 0 W | 2 / 5 | G9 (G5) |
| Z10 | 0 W | 0 W | 1 / 5 | G10 |
| Z11 | High | High | 2 / 5 | G11 |
| Z12 | 0 W | High | 0 | G12 |

Die ermittelten Gewichtungen in der Tabelle T4, werden zur Gewichtung der Beträge TA1 und TA2 der verschiedenen Pegelzustände Z9 -Z12 herangezogen, um den Gesamtbetrag GB zu bestimmen. Der gewichtete Gesamtbetrag GB sieht folgendermaßen aus:

$$
\begin{aligned}
GB = (&\sqrt{[Re\ 8B\_9 - Re\ 8C]^2 + [Im\ 8B\_9 + Im\ 8C]^2} \\
&+ \sqrt{[Re\ 8D - Re\ 8E\_9]^2 + [Im\ 8D + Im\ 8E\_9]^2}\,) * 0{,}4 \\
&+ (\sqrt{[Re\ 8B\_10 - Re\ 8C]^2 + [Im\ 8B\_10 + Im\ 8C]^2} \\
&+ \sqrt{[Re\ 8D - Re\ 8E\_10]^2 + [Im\ 8D + Im\ 8E\_10]^2}\,) * 0{,}2 \\
&+ (\sqrt{[Re\ 8B\_11 - Re\ 8C]^2 + [Im\ 8B\_10 + Im\ 8C]^2} \\
&+ \sqrt{[Re\ 8D - Re\ 8E\_11]^2 + [Im\ 8D + Im\ 8E\_11]^2}\,) * 0{,}4 \\
&+ (\sqrt{[Re\ 8B\_12 - Re\ 8C]^2 + [Im\ 8B\_12 + Im\ 8C]^2} \\
&+ \sqrt{[Re\ 8D - Re\ 8E\_12]^2 + [Im\ 8D + Im\ 8E\_12]^2}\,) * 0{,}0
\end{aligned}
$$

Die letzten beiden Beträge der Differenzen sind mit Null gewichtet, da sie keinen Beitrag zur Optimierung der Impedanz der Verbindungsleitung beitragen. Um ein breitbandiges Frequenzband zu erhalten wird anstelle eines einzelnen Ausdrucks

$[Re\ 8B\_11 - Re\ 8C]^2 + [Im\ 8B\_11 + Im\ 8C]2$

für FMCW-Systeme der lineare Mittelwert des Frequenzbandes oder für Puls-Systeme eine Gauß-Gewichtung um die Mittenfrequenz eingesetzt. Auch andere Gewichtungsverfahren sind hierbei möglich.

Fig. 7 zeigt ein zweites Diagramm entsprechend dem ersten Diagramm in Fig. 7, jedoch mit einer Gewichtung der Beträge TA1 und TA2 für jeden Pegelzustand. Die Gewichtung führt dazu, dass der Bereich 7A in mehrere kleinere Umschaltbereiche 9A, 9B, 9C unterteilt ist. Teilweise wie z. B. bei der Baugruppe D9 (Mischer) wurden Simulationswerte durch Messwerte ersetzt oder ergänzt.

Fig. 8 zeigt ein drittes Diagramm 15 entsprechend dem ersten und dem zweiten Diagramm 13, 14 in Fig. 6 und 7, bei dem die Pegelzustände keine Punkte sondern Pegelzustandsbereiche in Form von Punktewolken 10A, 10B, 10C darstellen. Die Größe der Pegelzustandsbereiche 10A, 10B, 10C richtet sich nach der Gewichtung des jeweiligen Pegelzustands.

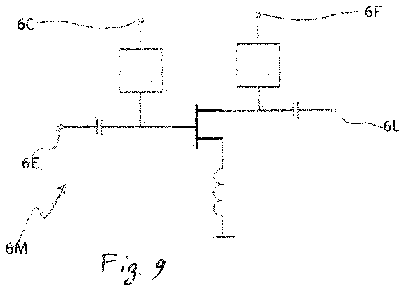

Fig. 9 zeigt den Schaltungsaufbau eines Verstärkers 6M des Feldgeräts, wie es für die Baugruppe D6 oder D8 realisiert wird (siehe Fig. 2). Als weiteres Beispiel wird das Gewichtungsverfahren auf den Verstärker 6M angewendet.

Im Folgenden werden nur die Tore des Verstärkers 6M betrachtet. Die Tore sind ein Signaleingang 6E, ein Signalausgang 6L, eine Steuerspannung 6C und eine Versorgungsspannung 6F.

Aus der Funktionsweise dieses Verstärkers 6M ergeben sich fünf Pegelzustände Z1 - Z5 mit jeweils einer Eingangsleistung P1 - P5 am Signaleingang 6E, wobei P1 = 0 und P4 ≈ P2 ist. Die Steuerspannung 6C kann die verschiedenen Werte U1, U2, U3 sowie die verschiedenen Steuerströme I1, I2 annehmen, wobei U2 = I2 = 0 ist.

Trägt man die Pegelzustände Z1 - Z5 in einer Spalte und die dazugehörigen Eingangsleistungen P1 - P5, Steuerspannungen U1 - U3 und Steuerströme I1, I2 in die jeweilige Reihe des jeweiligen Pegelzustands ergibt sich die nachfolgende Tabelle T5 für den Verstärker 6M.

Tabelle T5: Pegelzustände des Verstärkers 6M

| Pegelzust. | P (6E) | U (6C) | I (6F) | Beschreibung |
|---|---|---|---|---|
| Z1 | 0 W | 0 V | 0 A | HF-System offline, keine Reflexion |
| Z2 | P2 | U2 | 0 A | Senden von Pulsen, kein Empfang |
| Z3 | P3 | U3 | I2 | Empfangen, kein Senden |
| Z4 | P2 | U3 | I2 | Senden + Empfangen gleichzeitig |
| Z5 | P5 | U2 | 0 A | Erwarten von Empfangspulsen |

Aufgrund systemtheoretischer Überlegungen ist es sinnvoll die einzelnen Pegelzustände Z1 - Z5 zu gewichten. Die Gewichtungen der einzelnen Pegelzustände finden sich in der nachfolgenden Tabelle T6.

Tabelle T6: Gewichtete Pegelzustände des Verstärkers 6M

| Pegelzust. | P (6E) | U (6C) | I (6F) | Gew. | Beschreibung |
|---|---|---|---|---|---|
| Z1 | 0 W | 0 V | 0 A | 0 % | HF-System offline, keine Reflexion |
| Z2 | P2 | U2 | 0 A | 10 % | Senden von Pulsen, kein Empfang |
| Z3 | P3 | U3 | I2 | 60 % | Empfangen, kein Senden |
| Z4 | P2 | U3 | I2 | 10 % | Senden + Empfangen gleichzeitig |
| Z5 | P5 | U2 | 0 A | 20 % | Erwarten von Empfangspulsen |

Im Pegelzustand Z1 liegt zu wenig Leistung an den Eingangstoren des Verstärkers 6M an, um eine Störung durch Reflexionen zu verursachen. Aus diesem Grund wird dieser Pegelzustand mit Null gewichtet. Der Pegelzustand Z4 stellt einen sogenannten Nahbereich dar, in welchem das Signal von einer Baugruppe auf den anderen überschlägt. Aus Übersichtlichkeitsgründen ist die Leistung am Ausgang 6L in obenstehender Tabelle nicht aufgeführt. Die Tabelle T6 zeigt am Beispiel eines Verstärkers, wie die Pegelzustände Z1 - Z5 gewichtet werden können.

Die Baugruppe D1 stellt einen Pulsoszillator und die Baugruppe D6 stellt einen Sendeverstärker dar. Die beiden Baugruppen D1 und D6 weisen ein unterschiedliches Timing auf. Aus diesem Grund ergibt sich für eine verknüpfte Tabelle T7 zwischen den beiden Baugruppen.

Tabelle T7: Verknüpfung der Tabellen T5 und T6

| Pegelzust. | U (D1) | P (D1) | U (D6) | I (D6) | Gew. | Beschreibung |
|---|---|---|---|---|---|---|
| Z1 | low | 0 W | low | low | 0 % | Baugruppen offline |
| Z2 | low | 0 W | low | high | 10 % | Standby |
| Z3 | low | 0 W | high | high | 40 % | Verstärker an, kein Puls |
| Z4 | high | high | high | high | 45% | Puls wird verstärkt |
| Z5 | low | low | high | high | 5% | Nachschwingen Oszillator |

Hierbei ist U (D1) eine Spannung an der Baugruppe D1 (Oszillator), P (D1) die Ausgangsleistung der Baugruppe D1 (Oszillator), U (D6) die Steuerspannung der Baugruppe D6 (Verstärker) und I (D6) den Versorgungsstrom der Baugruppe D6 (Verstärker).

Die Erforschung dieses Verfahrens hat überraschenderweise ergeben, dass bei einem HF-Verstärker gemäß Fig. 9 eine geringe Steuerspannung 6C am Gate des FeldeffektTransistors 6H zu einer geringeren Rückwirkung, insbesondere einer geringeren Rückwirkung auf eine Impedanzänderung am Ausgang führt, wodurch die Transmission des Verstärkers vom Ausgang zum Eingang verringert wird. Ferner führt dies zu einer geringeren Änderung des Phasengangs am Ausgang zwischen ein- und ausgeschaltetem Versorgungsstroms 6F. Eine derartige Beschaltung soll hiermit auch Bestandteil dieser Erfindung sein.

**Bezugszeichenliste**

| | |
|---|---|
| 1a, 1b, 1c, 1d | Erster, zweiter, dritter, vierter Signalpuls |
| 2 | Verbindungsleitung |
| 6C | Steuerspannung |
| 6E | Signaleingang |
| 6F | Zweite Steuerspannung |
| 6L | Signalausgang |
| 6M | Hochfrequenz-Verstärkerbaugruppe |
| 7A | Bereich im P-I-Diagramm |
| 8A | Anpassstruktur |
| 8B | Erste Impedanz der ersten Baugruppe bei einem Pegelzustand |
| 8B_1, 8B_2, ... | Impedanzen der ersten Baugruppe E1 bei mehreren Pegelzuständen |
| 8E | Zweite Impedanz der zweiten Baugruppe bei einem Pegelzustand |
| 8E_1, 8E_2, ... | Impedanzen der zweiten Baugruppe E2 bei mehreren Pegelzuständen |
| 8C | Eingangsimpedanz der Verbindungsleitung |
| 8D | Ausgangsimpedanz der Verbindungsleitung |
| 9, 10, 11, 12 | Pegelzustände |
| 9A, 9B, 9C | Umschaltbareiche |
| 10A, 10B, 10C | Pegelzustandsbereiche |
| 13 | erstes Diagramm |
| 14 | Zweites Diagramm |
| 15 | Drittes Diagramm |
| A | Erste Hüllkurve |
| A1 | Erste ansteigende Flanke |
| A2 | Erster Bereich mit waagerechtem Verlauf |
| A3 | Erste abfallende Flanke |
| B | Zweite Hüllkurve |
| B1 | Zweite ansteigende Flanke |
| B2 | Zweiter Bereich mit waagrechtem Verlauf |
| B3 | Zweite abfallende Flanke |
| C1 | Überschwinger |
| C2 | Verkürzte Amplitude |
| C3 | Reflexionen |
| C4 | Mehrfach-Reflexionen |
| C5 | Schwebungen |
| D1 - D12 | Baugruppen |
| E1 | Erste Baugruppe |
| E2 | Zweite Baugruppe |
| F | Punkt auf der Verbindungsleitung |
| G | Dämpfungsmatte |
| GB | Gesamtbetrag |
| Z1, Z2, ... | Erster Pegelzustand, Zweiter Pegelzustand, ... |
| P_in (D4) | Erste Eingangsleistung |
| P_in (D8) | Zweite Eingangsleistung |
| P_out (D9) | Ausgangsleistung |
| I_out (D5) | Ausgangsstrom |
| ΔTA1 | Erste Differenz |
| ΔTA2 | Zweite Differenz |

| TA1 | Betrag der ersten Differenz |
| TA2 | Betrag der zweiten Differenz |
| TA | Summe aus dem Betrag der ersten Differenz und der Betrag dem zweiten Differenz |
| $Z\_E1$ | Impedanz der ersten baugruppe E1 bei einem Pegelzustand |
| $Z\_E2$ | Impedanz der zweiten baugruppe E2 bei einem Pegelzustand |

## Patentansprüche

1. Verfahren zur Optimierung der Impedanz eines Verbindungselements (2) zwischen einer ersten Baugruppe (E1) und einer zweiten Baugruppe (E2) einer Hochfrequenz-Vorrichtung, insbesondere eines Feldgeräts, wobei die erste Baugruppe (E1) und die zweite Baugruppe (E2) jeweils mindestens zwei Pegelzustände (Z1, Z2, Z1', Z2', ...) aufweisen, wobei das Verbindungselement (2) eine Eingangsimpedanz (8C) und eine Ausgangsimpedanz (8D) aufweist, wobei die erste Baugruppe (E1) in jedem ihrer mindestens zwei Pegelzustände (Z1, Z2, ...) jeweils eine Impedanz (8B_1, 8B_2, ...) aufweist, wobei die zweite Baugruppe (E2) in jedem ihrer mindestens zwei Pegelzustände (Z1', Z2', ...) jeweils eine Impedanz (8E_1, 8E_2, ...) aufweist, umfassend die Schritte, Bestimmen von jeweils einem Betrag (TA1_1, TA1_2, ...) einer Differenz ($\Delta$TA1_1, $\Delta$TA1_2, ...) für die erste Baugruppe (E1) zwischen der komplex konjugierten Eingangsimpedanz (8C*) und der jeweils einen Impedanz (8B_1, 8B_2, ...) der ersten Baugruppe (E1) in jedem ihrer mindestens zwei Pegelzustände (Z1, Z2,...), Bestimmen von jeweils einem Betrag (TA2_1, TA2_2, ...) einer Differenz ($\Delta$TA2_1, $\Delta$TA2_2, ...) für die zweite Baugruppe (E2) zwischen der komplex konjugierten Ausgangsimpedanz (8D*) und der jeweils einen Impedanz (8E_1, 8E_2, ...) der zweiten Baugruppe (E1) in jedem ihrer mindestens zwei Pegelzustände (Z1', Z2',...), Minimieren einer Summe (GB) der jeweiligen Beträge (TA1_1, TA1_2, ... ,TA2_1, TA2_2, ...) der ersten Baugruppe (E1) und zweiten Baugruppe (E2) bezüglich der Ein- und Ausgangsimpedanz (8C, 8D) des Verbindungselements (2).

2. Verfahren nach Anspruch 1, wobei die jeweiligen Beträge (TA1_1, TA1_2, ..., TA2_1, TA2_2, ...) vor dem Minimieren der Summe (GB) gewichtet werden.

3. Verfahren nach Anspruch 2, wobei mindestens eine der jeweiligen Beträge (TA1_1, TA1_2, ..., TA2_1, TA2_2, ...), die keinen Einfluss auf die Optimierung der Eingangs- und Ausgangsimpedanz (8C, 8D) des Verbindungselements (2) ausübt, mit Null gewichtet wird.

4. Verfahren nach Anspruch 2 oder 3, wobei die Gewichtung der mindestens einen der jeweiligen Beträge (TA1_1, TA1_2, ..., TA2_1, TA2_2, ...) aufgrund der Gewichtung der Eingangsleistung (P) und/oder der Eingangsspannung (U) und/oder des Eingangsstroms (I) der ersten oder zweiten Baugruppe (E1, E2) bestimmt wird.

5. Verbindungselement zur Optimierung der Impedanz zwischen einer ersten Baugruppe (E1) und einer zweiten Baugruppe (E2) einer Hochfrequenz-Vorrichtung, insbesondere eines Feldgeräts, wobei die erste Baugruppe (E1) und die zweite Baugruppe (E2) jeweils mindestens zwei Pegelzustände (Z1, Z2, Z1', Z2'...) aufweisen, wobei das Verbindungselement (2) eine Eingangsimpedanz (8C) und eine Ausgangsimpedanz (8D) aufweist, wobei die erste Baugruppe (E1) in jedem ihrer mindestens zwei Pegelzustände (Z1, Z2, ...) jeweils eine Impedanz (8B_1, 8B_2, ...) aufweist, wobei die zweite Baugruppe (E2) in jedem ihrer mindestens zwei Pegelzustände (Z1', Z2', ...) jeweils eine Impedanz (8E_1, 8E_2, ...) aufweist, wobei eine Summe (GB) aus einem Betrag (TA1_1, TA1_2, ...) einer Differenz ($\Delta$TA1_1, $\Delta$TA1_2, ...) für die erste Baugruppe (E1) zwischen einer komplex konjugierten Eingangsimpedanz (8C*) und der jeweils einen Impedanz (8B_1, 8B_2, ...) der ersten Baugruppe (E1) in jedem ihrer mindestens zwei Pegelzustände (Z1, Z2,...) und aus einem Betrag ($\Delta$TA2_1, $\Delta$TA2_2, ...) einer Differenz ($\Delta$TA2_1, $\Delta$TA2_2, ...) für die zweite Baugruppe (E2) zwischen einer komplex konjugierten Ausgangsimpedanz (8D*) und der jeweils einen Impedanz (8E_1, 8E_2, ...) der zweiten Baugruppe (E2) in jedem ihrer mindestens zwei Pegelzustände (Z1', Z2',...) bezüglich der Ein- und Ausgangsimpedanz (8C, 8D) des Verbindungselements (2) minimiert ist.

6. Verbindungselement nach Anspruch 5, wobei das Verbindungselement (2) eine Anpassstruktur aufweist, die eine Eingangs- und Ausgangsimpedanz (8C, 8D) aufweist, dessen Beträge (TA1_1, TA1_2, ...) der ersten Baugruppe (E1) und dessen Beträge (TA2_1, TA2_2, ...) der zweiten Baugruppe (E2) bezüglich der Eingangs- und Ausgangsimpedanz (8C, 8D) optimiert sind.

7. Verbindungselement nach Anspruch 5 oder 6, wobei das Verbindungselement (2) als eine elektrische Verbindungsleitung ausgestaltet ist.

8. Verbindungselement nach einem der Ansprüche 5 bis 7, wobei das Verbindungselement (2) mindestens einen Widerstand und/oder mindestens einen Kondensator und/oder mindestens eine Spule umfasst.

**Claims**

1. Procedure to optimize the impedance of a connecting element (2) between a first component (E1) and a second component (E2) of a high-frequency apparatus, particularly a field device,
   wherein the first component (E1) and the second component (E2) each have at least two level states (Z1, Z2, Z1', Z2', ...),
   wherein the connecting element (2) has an input impedance (8C) and an output impedance (8D),
   wherein in each of its at least two level states (Z1, Z2, ...) the first component (E1) has an impedance (8B_1, 8B_2, ...),
   wherein in each of its at least two level states (Z1', Z2', ...) the second component (E2) has an impedance (8E_1, 8E_2, ...),
   wherein said procedure comprises the following steps:

   Determination, in each case, of a value (TA1_1, TA1_2, ...) of a difference (ΔTA1_1, ΔTA1_2, ...) for the first component (E1) between the complexly conjugated input impedance (8C*) and the respective impedance (8B_1, 8B_2, ...) of the first component (E1) in each of its at least two level states (Z1, Z2, ...),
   Determination, in each case, of a value (TA2_1, TA2_2, ...) of a difference (ΔTA2_1, ΔTA2_2, ...) for the second component (E2) between the complexly conjugated output impedance (8D*) and the respective impedance (8E_1, 8E_2, ...) of the second component (E2) in each of its at least two level states (Z1', Z2', ...),
   Minimization of a sum (GB) of the respective values (TA1_1, TA1_2, ..., TA2_1, TA2_2, ...) of the first component (E1) and the second component (E2) with regard to the input and output impedance (8C, 8D) of the connecting element (2).

2. Procedure as claimed in Claim 1, wherein the respective values (TA1_1, TA1_2, ..., TA2_1, TA2_2, ...) are weighted before the minimization of the sum (GB).

3. Procedure as claimed in Claim 2, wherein at least one of the respective values (TA1_1, TA1_2, ..., TA2_1, TA2_2, ...) that does not influence the optimization of the input and output impedance (8C, 8D) of the connecting element (2) is weighted with zero.

4. Procedure as claimed in Claim 2 or 3, wherein the weighting of the at least one of the respective values (TA1_1, TA1_2, ..., TA2_1, TA2_2, ...) is determined on the basis of the weighting of the input power (P) and/or the input voltage (U) and/or the input current (I) of the first or second component (E1, E2).

5. Connecting element for the optimization of the impedance between a first component (E1) and a second component (E2) of a high-frequency apparatus, particularly a field device,
   wherein the first component (E1) and the second component (E2) each have at least two level states (Z1, Z2, Z1', Z2', ...),
   wherein the connecting element (2) has an input impedance (8C) and an output impedance (8D),
   wherein in each of its at least two level states (Z1, Z2, ...) the first component (E1) has an impedance (8B_1, 8B_2, ...),
   wherein in each of its at least two level states (Z1', Z2', ...) the second component (E2) has an impedance (8E_1, 8E_2, ...),
   wherein a sum (GB) - of a value (TA1_1, TA1_2, ...) of a difference (ΔTA1_1, ΔTA1_2, ...) for the first component (E1) between a complexly conjugated input impedance (8C*) and the respective impedance (8B_1, 8B_2, ...) of the first component (E1) in each of its at least two level states (Z1, Z2, ...) and
   of a value (TA2_1, TA2_2, ...) of a difference (ΔTA2_1, ΔTA2_2, ...) for the second component (E2) between a complexly conjugated output impedance (8D*) and the respective impedance (8E_1, 8E_2, ...) of the second component (E2) in each of its at least two level states (Z1', Z2', ...) - is minimized with regard to the input and output impedance (8C, 8D) of the connecting element (2).

6. Connecting element as claimed in Claim 5, wherein the connecting element (2) has an adaptation structure, which has an input and output impedance (8C, 8D) whose values (TA1_1, TA1_2, ...) of the first component (E1) and whose values (TA2_1, TA2_2, ...) of the second component (E2) are optimized with regard to the input and output impedance (8C, 8D).

7. Connecting element as claimed in Claim 5 or 6, wherein the connecting element (2) is designed as an electrical connecting cable.

8. Connecting element as claimed in one of the Claims 5 to 7, wherein the connecting element (2) comprises at least a resistor and/or at least a capacitor and/or at least a coil.

**Revendications**

1. Procédé destiné à l'optimisation de l'impédance d'un élément de liaison (2) entre un premier composant (E1) et un deuxième composant (E2) d'un dispositif haute fréquence, notamment un appareil de terrain,
le premier composant (E1) et le deuxième composant (E2) présentant chacun deux états de niveau (Z1, Z2, Z1', Z2', ...),
l'élément de liaison (2) présentant une impédance d'entrée (8C) et une impédance de sortie (8D),
le premier composant (E1) présentant dans chacun des au moins deux états de niveau (Z1, Z2, ...) respectivement une impédance (8B_1, 8B_2, ...),
le deuxième composant (E2) présentant dans chacun des au moins deux états de niveau (Z1', Z2', ...) respectivement une impédance (8E_1, 8E_2, ...),
lequel procédé comprend les étapes suivantes :

Détermination de respectivement une valeur (TA1_1, TA1_2, ...) d'une différence ($\Delta$TA1_1, $\Delta$TA1_2, ...) pour le premier composant (E1) entre l'impédance d'entrée conjuguée complexe (8C*) et l'impédance respective (8B_1, 8B_2, ...) du premier composant (E1) dans chacun de leur au moins deux états de niveau (Z1, Z2, ...),
Détermination d'une valeur (TA2_1, TA2_2, ...) respective d'une différence ($\Delta$TA2_1, $\Delta$TA2_2, ...) pour le deuxième composant (E2) entre l'impédance de sortie conjuguée complexe (8D*) et l'impédance (8E_1, 8E_2, ...) respective du deuxième composant (E2) dans chacun de leur au moins deux états de niveau (Z1', Z2', ...),
Minimisation d'une somme (GB) des valeurs (TA1_1, TA1_2, ..., TA2_1, TA2_2, ...) respectives du premier composant (E1) et du deuxième composant (E2) concernant l'impédance d'entrée et de sortie (8C, 8D) de l'élément de liaison (2).

2. Procédé selon la revendication 1, pour lequel les valeurs (TA1_1, TA1_2, ..., TA2_1, TA2_2, ...) respectives sont pondérées avant la minimisation de la somme (GB).

3. Procédé selon la revendication 2, pour lequel au moins l'une des valeurs (TA1_1, TA1_2, ..., TA2_1, TA2_2, ...) respectives, qui n'exerce aucune influence sur l'optimisation de l'impédance d'entrée et de sortie (8C, 8D) de l'élément de liaison (2), est pondérée avec zéro.

4. Procédé selon la revendication 2 ou 3, pour lequel la pondération de l'au moins une parmi les valeurs respectives (TA1_1, TA1_2, ..., TA2_1, TA2_2, ...) est déterminée sur la base de la pondération de la puissance d'entrée (P) et/ou de la tension d'entrée (U) et/ou du courant d'entrée (I) du premier et du deuxième composant (E1, E2).

5. Élément de liaison destiné à l'optimisation de l'impédance entre un premier composant (E1) et un deuxième composant (E2) d'un dispositif haute fréquence, notamment un appareil de terrain,
le premier composant (E1) et le deuxième composant (E2) présentant chacun deux états de niveau (Z1, Z2, Z1', Z2', ...),
l'élément de liaison (2) présentant une impédance d'entrée (8C) et une impédance de sortie (8D),
le premier composant (E1) présentant dans chacun des au moins deux états de niveau (Z1, Z2, ...) respectivement une impédance (8B_1, 8B_2, ...),
le deuxième composant (E2) présentant dans chacun des au moins deux états de niveau (Z1', Z2', ...) respectivement une impédance (8E_1, 8E_2, ...),
une somme (GB) - d'une valeur (TA1_1, TA1_2, ...) d'une différence ($\Delta$TA1_1, $\Delta$TA1_2, ...) pour le premier composant (E1) entre une impédance d'entrée conjuguée complexe (8C*) et l'impédance respective (8B_1, 8B_2, ...) du premier composant (E1) dans chacun de leur au moins deux états de niveau (Z1, Z2, ...) et
d'une valeur (TA2_1, TA2_2, ...) d'une différence ($\Delta$TA2_1, $\Delta$TA2 2, ...) pour le deuxième composant (E2) entre une impédance d'entrée conjuguée complexe (8D*) et l'impédance respective (8E_1, 8E_2, ...) du deuxième composant (E2) dans chacun de leur au moins deux états de niveau (Z1', Z2', ...) - étant minimisée concernant l'impédance d'entrée et de sortie (8C, 8D) de l'élément de liaison (2).

6. Élément de liaison selon la revendication 5, pour lequel l'élément de liaison présente une structure d'adaptation, qui présente une impédance d'entrée et de sortie (8C, 8D), dont les valeurs (TA1_1, TA1_2, ...) du premier composant (E1) et dont les valeurs (TA2_1, TA2_2, ...) du deuxième composant (E2) sont optimisées en termes d'impédance d'entrée et de sortie (8C, 8D).

7. Élément de liaison selon la revendication 5 ou 6, pour lequel l'élément de liaison (2) est conçu en tant que câble de raccordement électrique.

8. Élément de liaison selon l'une des revendications 5 à 7, pour lequel l'élément de liaison (2) comprend au moins une résistance et/ou au moins un condensateur et/ou au moins une bobine.

Fig. 1

Fig. 2

EP 3 039 785 B1

G

E1 — [ ] — E2

Fig. 3 (SdT)

F

2

E1 — •——— E2

← z_E1    z_E2 →

Fig. 4 (SdT)

8A

E1 —— 2 —— [ ] —— E2

Re 8B  Re 8C    Re 8D  Re 8E
Im 8B  Im 8C    Im 8D  Im 8E

Fig. 5

16

Fig. 6

Fig. 7

Fig. 8

Fig. 9

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 1168604 A1

- WO 2011134635 A1